# FASCICULE DE BREVET EUROPEEN

(11) **EP 4 343 817 B1**
(45) Date de publication et mention de la délivrance du brevet: **12.02.2025**
(21) Numéro de dépôt: 23198561.5
(22) Date de dépôt: 20.09.2023
(51) Int. Cl.: H01L 21/265, H01L 21/268, H01L 21/425, H01L 21/428

(54) **PROCÉDÉ DE CRISTALLISATION EN PHASE SOLIDE D'UNE COUCHE AMORPHE**
VERFAHREN ZUR FESTPHASENKRISTALLISATION EINER AMORPHEN SCHICHT
METHOD FOR SOLID PHASE CRYSTALLIZATION OF AN AMORPHOUS LAYER

(30) Priorité: 21.09.2022 FR 2209570
(43) Date de publication de la demande: 27.03.2024
(73) Titulaire: Commissariat à l'Energie Atomique et aux Energies Alternatives, 75015 Paris (FR)
(72) Inventeur: KERDILES, Sébastien, 38054 Grenoble cedex 09 (FR); ACOSTA ALBA, Pablo, 38054 Grenoble cedex 09 (FR); ALVAREZ ALONSO, Angela, 38054 Grenoble cedex 09 (FR); OPPRECHT, Mathieu, 38054 Grenoble cedex 09 (FR)
(74) Mandataire: Hautier IP

(56) Documents cités:
- ACOSTA ALBA PABLO ET AL: "Solid phase recrystallization induced by multi-pulse nanosecond laser annealing", vol. 3, 100053, 7 January 2021 (2021-01-07), pages 1 - 5, XP093049031, ISSN: 2666-5239, Retrieved from the Internet <URL:https://www.sciencedirect.com/science/article/pii/S2666523920300386/pdfft?md5=be1e474a92485890861636e7f6404fcb&pid=1-s2.0-S2666523920300386-main.pdf> [retrieved on 20230524], DOI: 10.1016/j.apsadv.2020.100053

## Description

### DOMAINE TECHNIQUE

La présente invention concerne le domaine de la cristallisation en phase solide d'une couche de matériau amorphe pour la microélectronique ou la nanoélectronique, notamment en présence de dopants à activer électriquement, en particulier afin d'obtenir une couche semi-conductrice. Elle trouve notamment, pour application particulièrement avantageuse, l'intégration verticale, dite « intégration séquentielle 3D », de composants électroniques.

### ETAT DE LA TECHNIQUE

Pour obtenir des régions dopées dans du silicium, il est courant de procéder à une implantation ionique des dopants et de recuire l'échantillon de sorte à guérir les défauts générés par l'implantation. Ce recuit favorise le placement des dopants sur les sites substitutionnels du cristal hôte. Le recuit habituel connu sous le sigle RTA (pour « Rapid Thermal Annealing » selon la terminologie anglo-saxonne) dure typiquement, pour du silicium, d'une seconde à quelques dizaines de secondes à des températures comprises entre 800 et 1100°C. Plus récemment, la durée de recuit a été raccourcie à quelques millisecondes de sorte à limiter la diffusion des dopants, dans une gamme de température similaire.

Il est aussi possible d'amorphiser volontairement la zone à doper via une pré-implantation à l'aide d'ions relativement lourds, tels que des ions Si⁺ ou Ge⁺ (une telle implantation ionique étant connue sous le sigle PAl pour « Pre-Amorphizing Implantation » selon la terminologie anglo-saxonne), puis de procéder à l'implantation des dopants dans cette région amorphisée. La recristallisation peut alors être obtenue par un recuit de quelques secondes à quelques minutes à des températures comprises entre 500 à 800°C. Toutefois, plus la température est basse, plus la recristallisation est lente, voire même quasiment nulle pour une température inférieure à 500°C.

Une approche plus récente est développée dans l'article d'Acosta Alba et al., paru dans Applied Surface Science Advances, 3 (2021), 100053, et intitulé « Solid phase recrystallisation induced by multi-pulse nanosecond laser annealing ». Cet article montre qu'un laser avec une impulsion de durée inférieure à 1 µs et une densité d'énergie un peu en dessous du seuil de fusion peut être mis en oeuvre pour recristalliser une couche de matériau amorphe préchauffé à l'aide d'un piédestal chauffant (ou « heating chuck » selon la terminologie anglo-saxonne) et en cumulant jusqu'à 1000 tirs sur une même zone, pour tout doucement, nanomètre par nanomètre, arriver à une recristallisation totale de la couche précédemment amorphisée. Par cette approche, la recristallisation est rendue possible sur une épaisseur de la couche amorphe inférieure à 20 nm. Toutefois, il a été expérimentalement observé que même en cumulant beaucoup plus de tirs laser, une recristallisation totale n'est pas atteignable par cette approche quand l'épaisseur de la couche amorphe est supérieure, notamment lorsqu'elle atteint 30 nm ou plus.

Un objet de la présente invention est donc de proposer une solution pour rendre plus efficace les procédés connus de cristallisation en phase solide d'une couche amorphe.

Un autre objet de la présente invention est de proposer un procédé de cristallisation en phase solide d'une couche amorphe qui permette de rendre possible la cristallisation d'une couche amorphe d'épaisseur plus élevée que ne le permettent les techniques de cristallisation antérieures qui visent à réduire le budget thermique.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation, on prévoit un procédé de cristallisation d'au moins une partie d'une couche amorphe à base d'un premier matériau, la couche amorphe :
a. étant comprise dans un empilement comprenant en outre une couche cristalline,
b. s'étendant directement au contact de la couche cristalline de l'empilement en formant une interface avec la couche cristalline, et
c. présentant une première face opposée à l'interface entre la couche amorphe et la couche cristalline, et
d. présentant, un seuil de fusion noté E_{M}, correspondant à la densité d'énergie à apporter à la couche amorphe pour atteindre une fusion du premier matériau, pour une épaisseur Ep de la couche amorphe définie entre la première face et l'interface de la couche amorphe avec la couche cristalline.

Le procédé comprend un recuit de cristallisation de la couche amorphe en la soumettant, par zones, à des impulsions laser, et est tel que, en chaque zone, les impulsions laser sont émises par séries d'impulsions, chaque impulsion présentant une densité d'énergie EDᵢ différente d'une série à une autre de sorte à maintenir la densité d'énergie des impulsions de chaque série en dessous du seuil de fusion E_{M}, ce dernier évoluant à mesure que la couche amorphe cristallise.

Ainsi, il est permis de cristalliser, en phase solide, entièrement, ou au besoin partiellement, la couche amorphe, de façon plus efficace que ne le permettent les techniques existantes. Également, il est permis de cristalliser, en phase solide, entièrement, ou au besoin partiellement, la couche amorphe, y compris lorsque cette dernière présente une épaisseur initiale supérieure à l'épaisseur maximale que permettent de cristalliser les techniques existantes.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

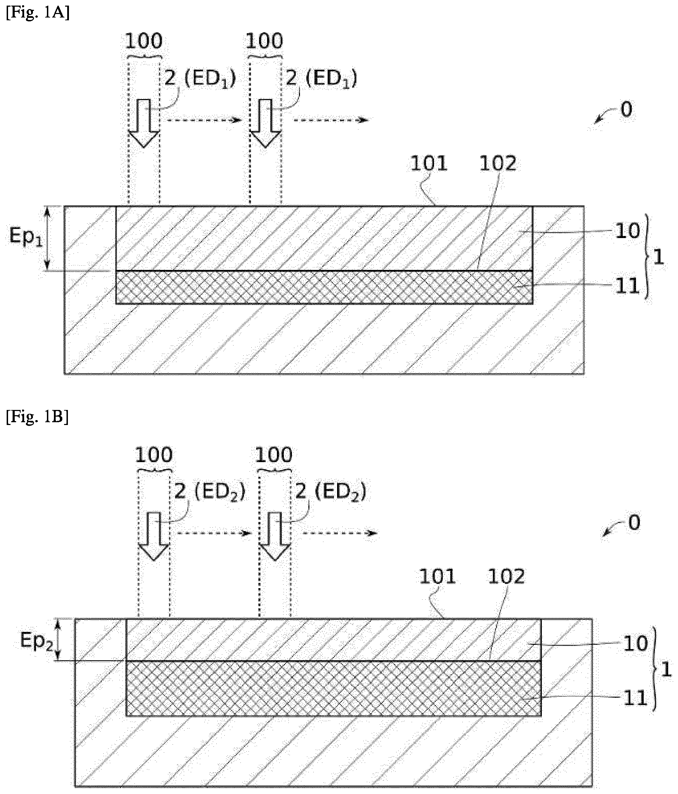

La figure 1A représente une vue schématique en coupe d'une structure micro/nanoélectronique sur laquelle est illustrée une première étape de recuit de cristallisation selon un mode de mise en œuvre du procédé de l'invention.
La figure 1B représente une vue schématique en coupe d'une structure micro/nanoélectronique obtenue à la suite de l'application de la première étape de recuit de cristallisation illustrée sur la figure 1A et sur laquelle est illustrée une deuxième étape de recuit de cristallisation selon un mode de mise en œuvre du procédé de l'invention.

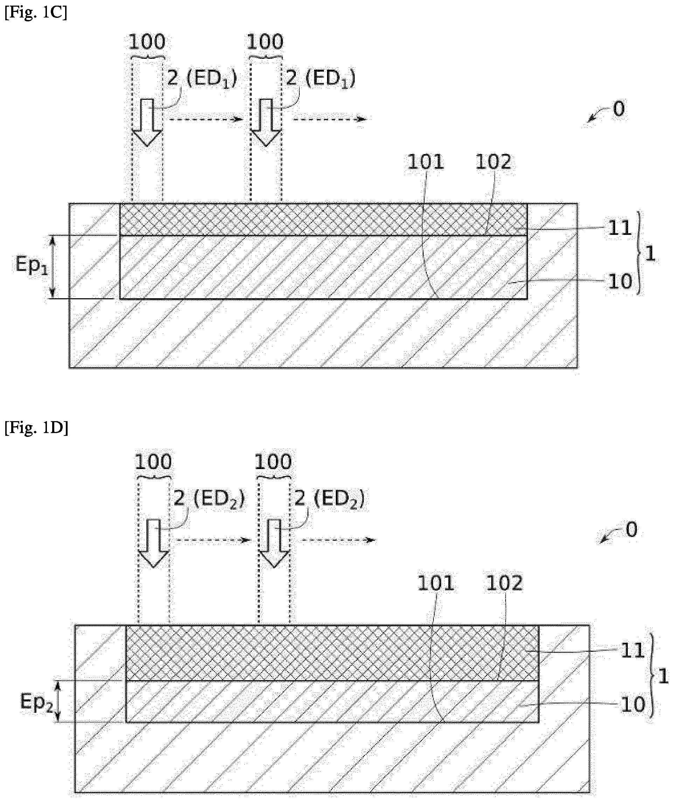

La figure 1C représente une vue schématique en coupe d'une autre structure micro/nanoélectronique que celle illustrée sur la figure 1A et sur laquelle est illustrée une première étape de recuit de cristallisation selon un mode de mise en œuvre du procédé de l'invention.
La figure 1D représente une vue schématique en coupe d'une structure micro/nanoélectronique obtenue à la suite de l'application de la première étape de recuit de cristallisation illustrée sur la figure 1C et sur laquelle est illustrée une deuxième étape de recuit de cristallisation selon un mode de mise en œuvre du procédé de l'invention.

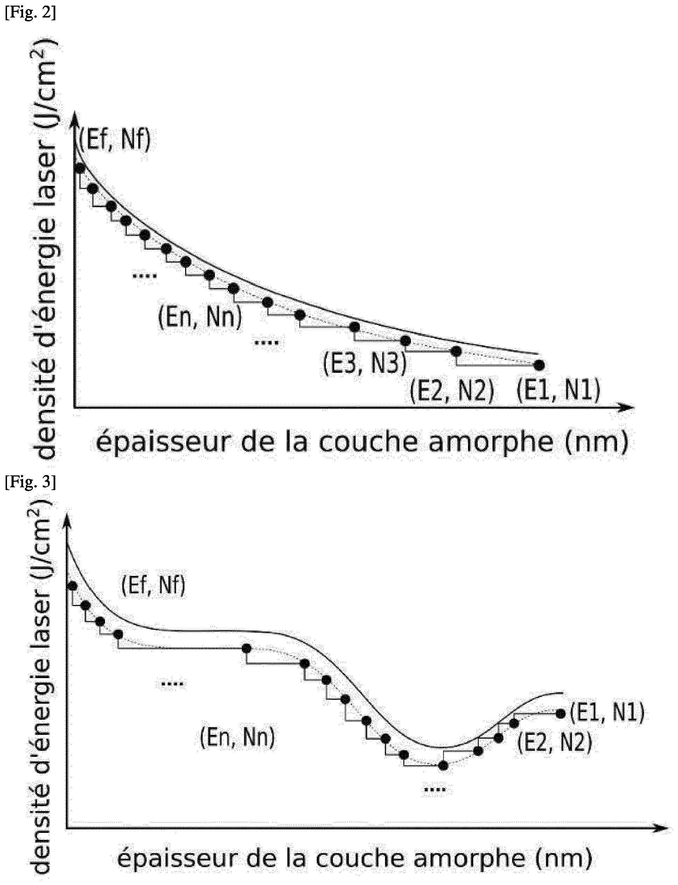

La figure 2 est une illustration graphique d'un premier mode de réalisation du procédé selon l'invention et consistant en plusieurs séries de Nᵢ tirs laser avec une densité d'énergie laser Eᵢ, où i indique le numéro de la série d'impulsions ; dans cet exemple, il est choisi de maintenir la densité d'énergie à environ 5% en dessous du seuil de fusion tout au long de la recristallisation.
La figure 3 est une illustration graphique d'un deuxième mode de réalisation du procédé selon l'invention et consistant en plusieurs séries de Nn tirs laser avec une densité d'énergie laser En, où n indique le numéro de la série d'impulsions ; dans cet exemple, il est choisi de maintenir la densité d'énergie à environ 8% en dessous du seuil de fusion.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions des différentes couches illustrées sur les figures 1A, 1B, 1C et 1D ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, la densité d'énergie EDᵢ des impulsions de chaque série est choisie de sorte que EDᵢ < E_{M}-8%×E_{M} et de préférence de sorte que EDᵢ < E_{M}-5%×E_{M}, et encore plus préférentiellement de sorte que EDᵢ < E_{M}-2%×E_{M}. L'on s'assure ainsi de ne pas dépasser le seuil de fusion, malgré les éventuelles variations, sur une amplitude de 1 à 2%, de densité d'énergie laser observables, entre impulsions d'une même série, sur la plupart des lasers pulsés.

Selon un exemple, la densité d'énergie EDᵢ des impulsions de chaque série est choisie de sorte que EDᵢ ≥ E_{M}-20%×E_{M} et de préférence de sorte que EDᵢ ≥ E_{M}-15%×E_{M}, et encore plus préférentiellement de sorte que EDᵢ ≥ E_{M}-10%×E_{M}. Le procédé permet ainsi l'adaptation dynamique de la densité d'énergie laser au fur et à mesure de la cristallisation de la couche amorphe pour maintenir la densité d'énergie des impulsions laser de chaque série dans un intervalle déterminé, par exemple dans l'intervalle [EM - 2%×EM, EM - 10%×EM].

Selon un exemple, le procédé comprend, avant le recuit de cristallisation de la couche amorphe, une première implantation configurée pour doper la couche amorphe, par implantation, dans la couche amorphe, de dopants, tels que As, Ga, B, P et Sb. La dose et l'énergie d'implantation des dopants peuvent être paramétrées de sorte à définir un profil de dopage désiré dans la couche amorphe. Le procédé permet dès lors d'obtenir une couche à base du premier matériau sous sa forme cristallisée en présentant un taux d'activation des dopants très haut. Selon cet exemple, chaque série d'impulsions comprend de préférence un minimum de 30 impulsions.

Selon un exemple, le procédé comprend, avant le recuit de cristallisation de la couche amorphe, une deuxième implantation configurée pour former la couche amorphe, par implantation, dans la couche amorphe, d'ions, dits lourds, tels que Si, Ge, Xe et Ar. Il est ainsi possible de contrôler finement l'épaisseur initiale de la couche amorphe et cette épaisseur peut être comprise entre 5 et 200 nm en fonction des paramètres de l'implantation amorphisante, et notamment en fonction de la dose et de l'énergie d'implantation des ions.

Selon les deux exemples précédents, la deuxième implantation dite 'amorphisante' peut être réalisée avant la première implantation dite 'dopante'.

Selon un exemple, l'épaisseur initiale de la couche amorphe peut être strictement supérieure à 20 nm, et par exemple supérieure ou égale à 25 nm.

Selon un exemple, l'un au moins parmi le premier matériau et le matériau à base duquel est constituée la couche cristalline peut être choisi parmi : Si, SiGe, Ge, SiC, GeSn et le diamant.

Selon un exemple, chaque série d'impulsions laser comprend entre 1 et 1000 impulsions, de préférence entre 5 et 50 impulsions.

Selon un exemple, la différence δED de densité d'énergie EDᵢ d'une série à une autre est comprise entre 5 et 100 mJ/cm², en particulier dans le cas d'impulsions laser dont la longueur d'onde se situe dans le domaine spectral des ultraviolets.

Selon un exemple, un intervalle de temps entre deux impulsions laser en une même zone est paramétré de sorte que l'empilement ait le temps de revenir à une température sensiblement égale à sa température avant réception d'une première des deux impulsions laser.

Selon un exemple, un intervalle de temps entre deux impulsions laser en une même zone est au minimum de 1 ms, en particulier dans le cas d'impulsions laser dont la longueur d'onde se situe dans le domaine spectral des ultraviolets.

Selon un exemple, les impulsions laser présentent une longueur d'onde située dans le domaine spectral des ultraviolets, et typiquement choisie parmi les valeurs suivantes : 293 nm, 308 nm et 355 nm.

Selon un exemple, le recuit de cristallisation est poursuivi jusqu'à cristallisation complète de la couche amorphe ou alternativement est arrêtée avant cristallisation complète de la couche amorphe.

Selon un exemple, une durée de chaque impulsion laser est inférieure ou égale à 3000 ns, préférentiellement inférieure ou égale à 1000 ns, et typiquement comprise entre 10 et 300 ns.

Selon un exemple, l'empilement est compris dans une structure micro/nanoélectronique, par exemple de type SOI, de type CMOS, ou de type jonction p-n.

On entend par un film à base d'un matériau A, un film comprenant ce matériau A et éventuellement d'autres matériaux.

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

Selon les techniques existantes de cristallisation, une série de tirs à énergie constante est pratiquée par zone de la couche à cristalliser. Les présents inventeurs ont constaté que cela ne permet une recristallisation que si la réflectivité et la conductivité thermique de la couche amorphe restent très proches de celles de la couche cristalline adjacente, c'est-à-dire dans le cas d'une épaisseur de la couche amorphe très faible, et typiquement inférieure à 15 nm. Dans l'art antérieur, la cristallisation est donc :
a. peu efficace, si au fur et à mesure que la cristallisation progresse, le seuil de fusion E_{M} s'éloigne de la densité d'énergie appliquée (qui est constante),
b. inadaptée, si au cours de la cristallisation, la densité d'énergie des impulsions, vient à dépasser légèrement le seuil de fusion E_{M}. Dans ce cas, la zone irradiée se met à fondre et cristallise en un matériau polycristallin, donc avec des propriétés dégradées en volume (défauts électriques, ...) comme en surface (rugosité).

Par ailleurs, il est connu que, dans une structure micro/nanoélectronique telle que celles concernées ici, la présence d'une couche amorphe modifie à la fois la réflectivité de la surface à cristalliser par rapport au cas d'un cristal parfait, et la conductivité thermique de l'empilement. La densité d'énergie des impulsions laser nécessaire pour atteindre une température donnée, par exemple pour atteindre le seuil de fusion E_{M} de la couche amorphe, dépend donc de l'épaisseur de cette couche.

En outre, le seuil de fusion E_{M} pour chaque épaisseur d'une couche amorphe déterminée, et le cas échéant en chaque zone de cette couche, peut être estimé, assez grossièrement, par le calcul (à partir des propriétés optiques et thermiques de l'empilement dont fait partie la couche amorphe) et/ou mesuré expérimentalement. Pour mesurer expérimentalement le seuil de fusion pour une épaisseur Ep donnée de la couche amorphe, il faut exposer plusieurs zones à différentes densités d'énergie laser ED de sorte à identifier la valeur pour laquelle la couche amorphe franchit le seuil de fusion E_{M}. Parmi les techniques de caractérisation permettant cette identification, on peut citer :
a. la réflectivité résolue dans le temps or TRR (pour « time-resolved reflectivity » selon la terminologie anglo-saxonne) qui permet de détecter un changement brutal de réflectivité quand le matériau amorphe passe en phase liquide,
b. la microscopie électronique en transmission (ou TEM pour « Transmission Electron Microscopy » selon la terminologie anglo-saxonne) qui permet d'observer en section transverse la structure après recristallisation dans laquelle la couche initialement amorphe devient polycristalline au-delà du seuil de fusion E_{M},
c. la scatérométrie (ou scatterometry ou haze measurements selon la terminologie anglo-saxonne).

Au-delà du seuil de fusion, la couche initialement amorphe et transformée en matériau polycristallin diffuse subitement la lumière très différemment en raison des nombreux grains qui la composent et de l'éventuelle rugosité apparue en surface si ladite couche affleure.

Il est donc admis qu'une personne de l'art sait, et saura sans doute d'autant mieux à l'avenir, déterminer, pour une structure donnée, l'évolution du seuil de fusion E_{M} en fonction de l'épaisseur de la couche amorphe à cristalliser.

Le procédé selon l'invention exploite avantageusement les constats énoncés ci-dessus.

Plus particulièrement, et en référence à la figure 1A, le procédé selon l'invention permet, à partir de l'évolution du seuil de fusion E_{M} en fonction de l'épaisseur de la couche amorphe 10 à cristalliser (telle que représentée graphiquement sur chacune des figures 2 et 3), ou en fonction de la position d'un front de cristallisation de la couche amorphe 10, de définir des conditions, de préférence optimales, de cristallisation de cette couche 10 par recuit.

Comme l'illustrent les figures 1A et 1C, la couche amorphe 10, constituée à base d'un premier matériau au moins en partie sous forme amorphe, est comprise dans un empilement 1. L'empilement 1 comprend au moins la couche amorphe 10 et une couche cristalline 11, à base d'un deuxième matériau sous forme cristalline. La couche amorphe 10 s'étend directement au contact de la couche cristalline 11. La couche amorphe 10 peut être par exemple au-dessus, au-dessous ou à côté de la couche cristalline 11 dans l'empilement 1. La couche amorphe 10 présente plus particulièrement :
a. une interface 102 avec la couche cristalline 11, et
b. une première face 101 opposée à son interface 102 avec la couche cristalline 11. C'est le mouvement de l'interface 102 au cours de la mise en œuvre du procédé de cristallisation qui matérialise l'avancée du front de cristallisation de la couche amorphe 10.

La couche amorphe 10 présente ainsi initialement une épaisseur Ep₁ définie entre sa première face 101 et l'interface 102.

Notons ici que la couche cristalline 11 est de préférence d'une épaisseur d'au moins 1 nm, préférentiellement d'au moins 3 nm et encore plus préférentiellement d'au moins 5 nm ; l'on s'assure ainsi que la couche cristalline 11 constitue un germe de croissance propre à permettre la propagation de sa nature cristalline à la couche amorphe 10. Par recristallisation en phase solide notons que l'énergie thermique permettant cette recristallisation est apportée par le recuit laser.

Notons encore que l'un au moins parmi le premier matériau et le deuxième matériau peut être choisi parmi : Si, SiGe, Ge, SiC, GeSn et le diamant. Ils peuvent être identiques ou différents entre eux.

Notons par ailleurs que, si la première face 101 et l'interface 102 telles qu'illustrées sur les figures 1A et 1B sont planes, ces illustrations ne sont pas limitatives du procédé selon l'invention qui peut être mis en oeuvre avec une première face 101 et/ou une interface 102 non planes, voire au contraire structurées, l'épaisseur de la couche amorphe 10 étant au besoin déterminée par zone 100.

Le procédé comprend, comme selon les techniques existantes, un recuit de cristallisation de la couche amorphe 10 en la soumettant à des impulsions laser 2.

Le procédé de cristallisation ici proposé se distingue des techniques existantes au moins en ce que, par zone 100, le recuit de cristallisation comprend plusieurs séries d'impulsions laser 2 à des densités d'énergie adaptées au fur et à mesure de l'avancée du front de cristallisation de la couche amorphe 10.

Notons ici que, relativement à l'exemple illustré sur la figure 1A, la couche amorphe 10 peut être surmontée d'une ou plusieurs couches minces diélectriques (par ex : SiO2, Si3N4). Ainsi, l'illustration de la figure 1A sur laquelle la première face 101 de la couche amorphe 10 est exposée n'est pas limitative du procédé selon l'invention. En outre, et en référence à la figure 1C, la couche amorphe 10 peut être surmontée de la couche cristalline 11. La couche cristalline 11 servant de germe de croissance, il peut être considéré que le front de cristallisation se déplace depuis l'interface 102 vers la première face 101 de la couche amorphe 10 ; cette considération ne limite toutefois pas le procédé selon l'invention.

En comparant les figures 1A et 1C entre elles, il apparaît que les impulsions laser 2 peuvent être émises vers l'interface 102 à travers la couche amorphe 10 comme illustré sur la figure 1A ou à travers la couche cristalline 11 comme illustré sur la figure 1C. Notons que les impulsions laser 2 peuvent encore être émises à travers au moins une couche mince diélectrique, notamment lorsque la couche amorphe 10 est surmontée d'une ou plusieurs couches minces diélectriques.

Le procédé comprend, pour commencer, l'application par zone 100 de N₁ tirs laser avec une densité d'énergie ED₁, la densité d'énergie ED₁ étant choisie de sorte à maintenir la densité d'énergie des impulsions 2 de cette première série en dessous du seuil de fusion E_{M1}, et par exemple dans l'intervalle [E_{M1}-2%× E_{M1}, E_{M1}-20%× E_{M1}], où E_{M1} est la valeur du seuil de fusion initial (défini pour l'épaisseur initiale Ep₁ de la couche amorphe 10). Cette première série, une fois appliquée en chaque zone 100, permet de cristalliser quelques nanomètres de la couche amorphe 10, généralement depuis son interface 102 et en direction de la première face 101. La première série d'impulsions a pour effet de changer la réflectivité de l'empilement 1, voire de la couche amorphe 10.

Cette cristallisation déplace donc l'interface 102 entre portion amorphe et cristalline de l'empilement 1, ou équivalemment le front de cristallisation. L'épaisseur de la couche amorphe 10 est alors réduite par cette première série d'impulsions. Cette nouvelle épaisseur de la couche amorphe 10 est notée Ep₂ en figures 1B et 1D.

Sur la figure 1B, le front de cristallisation se déplace vers le haut à mesure que le recuit de cristallisation est implémenté, tandis que, sur la figure 1D, le front de cristallisation va se déplacer vers le bas à mesure que le recuit de cristallisation est implémenté.

Après la première série d'impulsions 2, le seuil de fusion devient E_{M2} du fait que la couche amorphe 10 a une nouvelle épaisseur Ep₂ plus faible que l'épaisseur initiale Ep₁.

Une deuxième série de N₂ tirs avec une densité d'énergie ED₂ est alors appliquée de sorte à continuer la cristallisation, ED₂ étant choisie de sorte à maintenir la densité d'énergie des impulsions 2 de la deuxième série en dessous du seuil de fusion E_{M2}, et de préférence dans l'intervalle [E_{M2}-2%×E_{M2}, E_{M2}-20%×E_{M2}], où E_{M2} est la valeur du seuil de fusion atteinte à la suite de l'application de la première série d'impulsions 2. Le seuil de fusion E_{M2} est donc défini pour l'épaisseur, qu'il reste à cristalliser, de la couche amorphe 10 après la première série d'impulsions 2.

Plusieurs séries d'impulsions peuvent ainsi être appliquées, successivement et par zone 100, jusqu'à recristallisation éventuellement complète de la couche amorphe 10.

Pour chaque série, le nombre de tirs laser, Nᵢ, est compris entre 1 et 1000, typiquement entre 5 et 50.

La variation de densité d'énergie δED d'une série à l'autre est choisie de sorte à maintenir la densité d'énergie toujours très proche du seuil de fusion E_{M} sans jamais le dépasser ; elle est typiquement comprise entre 10 et 100 mJ/cm² dans le cas d'une laser UV (par exemple d'une longueur d'onde sensiblement égale à 308 nm) avec une durée d'impulsion de 160 ns, par exemple mesurée comme la largeur à mi-hauteur (ou « full width at half maximum (FWHM) » selon la terminologie anglo-saxonne) de l'impulsion 2. Ainsi, de préférence, la densité d'énergie est maintenue, pour chaque énième série, entre E_{Mn} - 2%×E_{Mn} et E_{Mn} -20%×E_{Mn}, de préférence entre E_{Mn} -2%×E_{Mn} et E_{Mn}-15%×E_{Mn}, et encore plus préférentiellement entre E_{Mn} -2%×E_{Mn} et E_{Mn}-10%×E_{Mn}, de sorte à cristalliser la couche amorphe 10 le plus efficacement possible, et notamment avec le moins de tirs laser possibles par série.

Notons que l'intervalle de temps entre deux impulsions 2 sur une même zone 100 est de préférence suffisamment important pour que la structure 0 en cours de traitement, et en particulier l'empilement 1, ait le temps de refroidir avant qu'un nouveau tir laser vienne de nouveau irradier la zone 100. Avec un laser UV (par exemple d'une longueur d'onde sensiblement égale à 308 nm) et une durée d'impulsion de l'ordre de 50 à 200 ns, un intervalle de temps strictement supérieur à 1 ms suffit.

Notons encore que, la valeur du seuil de fusion E_{M}, dépend non seulement de l'empilement 1 via les matériaux et l'épaisseur des différentes couches, notamment Ep, mais aussi de la durée des impulsions 2 et donc du choix du laser pour faire ce recuit. A longueur d'onde constante, plus la durée des impulsions 2 sera courte, plus les valeurs de E_{M} seront faibles.

Le procédé de cristallisation tel qu'introduit ci-dessus prévoit ainsi d'adapter dynamiquement, entre séries d'impulsions 2, la densité d'énergie ED à laquelle la couche amorphe 10 est soumise pour être recuite, de sorte à ne jamais dépasser le seuil de fusion E_{M} de la couche amorphe 10, et donc de sorte à rester en phase solide, malgré la variation du seuil de fusion E_{M} du fait en particulier de la cristallisation progressive de la couche amorphe 10, au cours de la mise en œuvre du procédé. Plus particulièrement, la densité d'énergie ED est adaptée à la hausse ou à la baisse, au fur et à mesure que la cristallisation consomme l'épaisseur Ep de la couche amorphe 10 et change donc la densité d'énergie laser ED nécessaire pour atteindre la fusion. Il est ainsi permis de cristalliser entièrement, ou au besoin partiellement, la couche amorphe 10, y compris lorsque celle-ci présente une épaisseur initiale supérieure à 20 nm, de préférence supérieure à 30 ou 50 nm, et pouvant aller jusqu'à au moins 200 nm. En outre, et comme nous le détaillerons plus bas, moins d'impulsions laser 2 sont requises, relativement aux techniques de cristallisation existantes, afin de parvenir à une même épaisseur cristallisée, ce qui fait du procédé proposé ici une technique de cristallisation plus efficace que les techniques de cristallisation existantes.

Notons que, sur les figures 1A, 1B, 1C et 1D, les flèches horizontales en pointillés illustrent un déplacement du laser d'une zone 100 à une autre. Ce déplacement peut dans l'absolu être continu, mais il est en pratique réalisé par sauts de puce. Notons encore que plusieurs lasers peuvent être utilisés simultanément, chacun pointant vers une zone 100 qui lui est propre. Notons par ailleurs que chaque impulsion définit une zone 100 irradiée, de sorte que l'interface 102 peut être « découpée » en une pluralité de zones 100 ; ces dernières se chevauchant ou non entre elles.

Les figures 2 et 3 illustrent chacune une adaptation dynamique découlant de la mise en œuvre du procédé selon l'invention. La courbe pleine y représente l'évolution du seuil de fusion E_{M} en fonction de l'épaisseur Ep de la couche amorphe 10. La courbe en pointillé de la figure 2 a été obtenue en soustrayant, à la courbe pleine, 5 % de sa valeur à l'ordonnée. La courbe en pointillé de la figure 3 a été obtenue en soustrayant, à la courbe pleine, 8 % de sa valeur à l'ordonnée.

La figure 2 illustre l'adaptation dynamique qui découle de la mise en œuvre du procédé selon l'invention dans le cas d'une évolution monotone du seuil de fusion E_{M} en fonction de l'épaisseur Ep de la couche amorphe 10. On y observe que la densité d'énergie des impulsions 2 varie effectivement par étapes, ici en croissant à mesure que l'épaisseur Ep de la couche amorphe 10 diminue.

La mise en œuvre du procédé selon l'invention n'est pas pour autant limitée à une évolution monotone du seuil de fusion E_{M} en fonction de l'épaisseur Ep de la couche amorphe 10. Par exemple, le procédé selon l'invention peut être mis en œuvre lorsque l'évolution du seuil de fusion E_{M} en fonction de l'épaisseur de la couche amorphe 10 varie de la façon illustrée sur la figure 3, en présentant un point d'inflexion et/ou un minimum local. La mise en œuvre du procédé s'étend encore à une évolution du seuil de fusion E_{M} en fonction de l'épaisseur de la couche amorphe 10 qui présenterait un maximum local ou qui ne serait pas monotone.

Un des objectifs de la cristallisation permise par la mise en œuvre du procédé selon l'invention consiste à activer des dopants compris dans la couche amorphe 10, de sorte à pouvoir exploiter ses propriétés semi-conductrices une fois la couche amorphe 10 au moins partiellement cristallisée.

Afin d'atteindre cet objectif, le procédé peut comprendre, avant le recuit de cristallisation de la couche amorphe 10, une première implantation configurée pour doper la couche amorphe 10, par implantation, au moins dans la partie à cristalliser de la couche 10, de dopants. De tels dopants peuvent par exemple être au moins l'un choisi parmi : As, Ga, B, P et Sb.

La dose et l'énergie d'implantation des dopants peuvent être paramétrées de sorte à définir un profil de dopage désiré dans la couche amorphe 10. Le procédé selon l'invention permet dès lors d'obtenir une couche à base du premier matériau sous sa forme cristallisée, en présentant un très haut taux d'activation des dopants.

Le procédé peut comprendre en outre, avant le recuit de cristallisation de la couche amorphe 10, et de préférence avant l'étape d'implantation de dopants dans la couche amorphe 10, une deuxième implantation configurée pour amorphiser le premier matériau, destiné à former la couche amorphe 10. Cette deuxième étape d'implantation peut plus particulièrement consister en l'implantation d'ions dits lourds (dont la masse atomique est supérieure ou égale à celle du Si), tels qu'au moins l'un choisi parmi : Si, Ge, Xe et Ar.

Il est ainsi possible de contrôler finement l'épaisseur initiale Ep₁ de la couche amorphe 10 et cette épaisseur initiale Ep₁ peut être comprise entre 5 et 200 nm en fonction des paramètres de l'implantation amorphisante, et notamment en fonction de la dose et de l'énergie d'implantation des ions.

En alternative, l'amorphisation pourrait être due à la réalisation d'une gravure par plasma d'une couche de surface. De telles gravures sont en effet connues pour présenter « l'inconvénient » d'amorphiser le matériau sous-jacent, et en particulier le silicium, typiquement sur une épaisseur pouvant atteindre 15 nm.

L'implantation amorphisante est optionnelle notamment dans le cas où la dose et l'énergie d'implantation des dopants conduiraient à une amorphisation de la zone implantée de dopants. Par exemple, l'implantation ionique de certains dopants comme le phosphore ou l'arsenic (entre autres) permet également de rendre la zone implantée amorphe, sans avoir besoin de procéder à une implantation amorphisante par ions lourds.

La couche amorphe 10 peut donc avoir été volontairement rendue amorphe, par amorphisation ; on parle alors équivalemment de « couche amorphe » ou de « couche amorphisée », et l'on peut alors parler de « recristallisation », plutôt que de « cristallisation ».

Notons en outre que les deux implantations, celle conduisant à l'amorphisation et celle introduisant les dopants, peuvent se décomposer en plusieurs implantations. Par exemple, l'implantation amorphisante peut consister en une combinaison d'implantations avec un ou plusieurs ions, avec une ou plusieurs énergies différentes. L'implantation de dopants peut elle aussi consister en une combinaison d'implantations d'un ou plusieurs dopants, avec éventuellement plusieurs énergies différentes de sorte à introduire un premier dopant plus profondément qu'un second ; par exemple, il est possible d'implanter du bore B dans du SiGe, en tant que premier matériau destiné à constituer la couche amorphe 10, à une profondeur comprise entre 0 et 40 nm, puis du gallium Ga dans ce même SiGe à une profondeur comprise entre 0 et 10 nm.

Une autre variante pourrait consister à arrêter la cristallisation à une épaisseur/profondeur désirée. Par exemple, dans le cas d'une région pré-amorphisée sur une épaisseur sensiblement égale à 50 nm, on peut décider d'arrêter la cristallisation à 10 nm de la première face 101 de la couche amorphe 10 de sorte à conserver une couche amorphe de 10 nm, qui peut être utile par exemple pour la formation de contact par siliciuration. La cristallisation par recuit selon l'invention permet donc aussi de cristalliser la couche amorphe 10 sur une épaisseur contrôlée, plus facilement que ne le permet un recuit classique par RTA, ou plus généralement par RTP (pour « Rapid Thermal Processing » selon la terminologie anglo-saxonne).

L'empilement 1 peut être compris dans une structure 0 microélectronique ou nanoélectronique. Parmi les structures micro/nanoélectronique concernées ici, on peut citer celles dites de type SOI dans laquelle au moins une partie de la couche amorphe 10 serait destinée à former une couche semiconductrice, ou celles dites de type CMOS (pour « Complementary metal-oxide-semiconductor » selon la terminologie anglo-saxonne), ou encore celles dites de jonction p-n, c'est-à-dire comprenant au moins deux couches avec des dopants de types opposés p et n.

Il est d'ailleurs à noter que le procédé selon l'invention est d'une mise en œuvre particulièrement pertinente dans le cas d'une structure 0 ne pouvant pas être recuite par RTP, sans être désavantageusement impactée, notamment en raison de la présence de composants microélectronique ou nanoélectronique, par exemple enterrés, sensibles aux hautes températures, et typiquement aux températures supérieures à 400°C. La mise en œuvre du procédé de cristallisation selon l'invention, en particulier en utilisant un laser dans l'ultraviolet, permet de ne chauffer que la partie de la structure 0 qui est à cristalliser et de maintenir le reste de la structure 0 en dessous d'une température modérée et acceptable, au-delà de laquelle les propriétés de la structure 0 pourraient être altérées. Il est alors possible de cristalliser une couche amorphe 10 éventuellement épaisse et d'activer ses dopants, en ne chauffant que cette dernière et en ne chauffant pas significativement, voire pas du tout, le reste de la structure 0. L'on comprend ainsi que le procédé selon l'invention est particulièrement adapté à une application en intégration séquentielle 3D (par exemple de type : CoolCube^{™} (Cf. par exemple IEEE Trans. Electr. Dev. Vol. 68 N°7 p. 3142 (2021)), CMOS froid, etc.).

A titre illustratif et nullement limitatif, sont fournis ci-dessous, sous la forme d'un tableau, des exemples de mise en œuvre du procédé selon l'invention.

Dans tous ces exemples, le recuit de cristallisation est effectué à l'aide d'un laser XeCl de longueur d'onde 308 nm et de durée d'impulsion 160 ns (FWHM). La densité d'énergie appliquée par chaque impulsion 2, exprimée en J/cm², dépend directement du type de laser. La mise en œuvre d'un autre laser, c'est-à-dire avec un rayonnement de longueur d'onde différente et/ou de durée d'impulsion différente, nécessiterait d'adapter la densité d'énergie pour conduire à une cristallisation similaire.

Une première série d'exemples concerne des échantillons de Si pré-amorphisés sur une épaisseur de 30 nm par implantation de Ge à une dose de 1×10¹⁵ ions/cm² avec une énergie d'implantation sensiblement égale à 5 keV, et dopés à l'aide de Bore à une dose de 1×10¹⁵ ions/cm² avec une énergie d'implantation sensiblement égale à 2 keV.

Dans cette configuration et avec le laser susmentionné, la fusion de la couche amorphisée 10 peut être constatée pour des densités d'énergie supérieure ou égale à 1,20 J/cm². Pour comparaison, la fusion d'un échantillon équivalent mais non amorphisé intervient à partir de 1,70 J/cm². La cristallisation en phase solide de la couche amorphisée peut donc être initiée à une densité d'énergie inférieure à 1,20 J/cm².

Pour comparaison, des essais de recristallisation ont été effectués à densité d'énergie constante en appliquant la technique, antérieure à la présente invention, qui est décrite dans l'article d'Acosta Alba *et al.* susmentionné. Ainsi, jusqu'à 1000 tirs laser par zone 100 avec chacune parmi une densité d'énergie de 1,15 et une densité d'énergie de 1,10 J/cm² ont été appliqués à la couche amorphisée 10. Il a été observé que la recristallisation n'est que partielle dans ces conditions. Ceci illustre que, dans ce cas, les techniques de cristallisation antérieures à l'invention ne permettent pas, à tout le moins efficacement, de parvenir au résultat désiré.

Sur le même type d'échantillons, plusieurs modes de mise en œuvre du procédé selon l'invention ont en revanche permis de cristalliser l'intégralité de la couche initialement amorphisée 10. Ces procédés sont caractérisés par :
a. Une densité d'énergie initiale, EDi, nécessairement en dessous de la valeur conduisant à la fusion en début de traitement, ici en dessous de 1,20 J/cm² ;
b. Une densité d'énergie finale, EDf, nécessairement en dessous de la valeur conduisant à la fusion dans le cas d'un échantillon non amorphisé, ici en dessous de 1,70 J/cm² ;
c. Un incrément en densité d'énergie, δED, pouvant par exemple être défini comme une fraction de la différence entre la valeur de la densité d'énergie finale et la valeur de densité d'énergie finale, de sorte à définir en proportion le nombre de séries d'impulsions 2 à réaliser ; et
d. Le nombre N de tirs par zone 100, par série d'impulsions 2.

Le tableau ci-dessous illustre une première série d'exemples de mise en œuvre du procédé selon l'invention ayant conduit à une recristallisation complète (nombre total de tirs en gras) ou ayant échoués (nombre total de tirs en italique), et permet de comparer les résultats de ces mises en œuvre avec un exemple de mise en œuvre de la technique à densité d'énergie constante qui est décrite dans l'article d'Acosta Alba et al. susmentionné (en deuxième ligne du tableau) :

**Tableau**

| EDi (J/cm²) | EDi (J/cm²) | δED (J/cm²) | N | Nombre total de tirs |
|---|---|---|---|---|
| 1.10 | 1.10 | 0 (état de l'art : ED constante) | 1000 | 1000 |
| 1.10 | 1.60 | 0.025 | 1 | *21* |
| | | | 5 | **105** |
| | | | 10 | **210** |
| | | | 30 | **630** |
| | | | 100 | **2100** |
| | | 0.050 | 1 | *11* |
| | | | 5 | **55** |
| | | | 10 | **110** |
| | | | 30 | **330** |
| | | | 100 | **1100** |
| | | 0.100 | 1 | *6* |
| | | | 5 | *30* |
| | | | 10 | *60* |
| | | | 30 | **180** |
| | | | 100 | **600** |

Notons tout d'abord que la mise en œuvre de la technique à densité d'énergie constante (deuxième ligne du tableau) ne permet pas, même après 1000 tirs de cristalliser entièrement la couche amorphe qui, dans l'exemple donné, présente une épaisseur de 30 nm, supérieure à l'épaisseur maximale de 20 nm étudiée dans l'article d'Acosta Alba *et al.* susmentionné.

L'on constate que, ce qui était impossible selon l'état de l'art (avec densité d'énergie constante) même après 1000 tirs, devient possible en augmentant graduellement la densité d'énergie pour s'adapter à l'évolution du front de cristallisation. Plusieurs combinaisons sont même possibles selon le choix de l'incrément de densité d'énergie δED et le nombre N de tirs par niveau intermédiaire d'énergie.

En outre, le nombre total de tirs permettant la cristallisation complète peut être optimisé selon le but recherché. On peut chercher à cristalliser avec un minimum de tirs. Ici, 55 tirs suffisent en choisissant un incrément δED de 50 mJ/cm² et N=5 tirs par niveau de densité d'énergie.

Il est également possible de chercher d'autres caractéristiques, comme une meilleure activation des dopants. Il a alors été constaté qu'il est préférable d'opter pour des mises en œuvre du procédé selon l'invention avec au moins N=30 tirs par niveau de densité d'énergie.

Une amélioration possible de ces exemples de mise en œuvre du procédé selon l'invention consiste à pratiquer le recuit de cristallisation alors que l'échantillon est préchauffé, par exemple à l'aide d'un piédestal chauffant. Dans le cas d'un empilement 1, et plus particulièrement d'une couche amorphe 10, à base de Si ou SiGe, cette assistance peut être réglée entre 25 et 450°C typiquement. Cela permet de réduire encore plus le nombre de tirs par niveau de densité d'énergie nécessaires à l'atteinte du résultat recherché, éventuellement à l'atteinte d'une cristallisation complète. Notons que les exemples compulsés dans le tableau ci-dessus ont été obtenus par des mises en œuvre du procédé en l'absence d'un tel préchauffage.

Les exemples de mise en œuvre pour lesquels la cristallisation n'est pas satisfaisante (cas marqués par un nombre total de tirs en italique dans le tableau ci-dessus) correspondent à des combinaisons avec trop peu de tirs par niveau de densité d'énergie. L'évolution de densité d'énergie est alors trop rapide par rapport à l'avancée du front de recristallisation. Lors du traitement, la densité d'énergie laser dépasse alors le seuil de fusion E_{M} et provoque la fusion du reliquat de la couche amorphe 10, puis sa solidification dite 'explosive' en poly-Si, ce qui n'est pas désiré d'un point de vue électrique.

Une seconde série d'exemples concerne des échantillons de SiGe avec 20% de Ge, pré-amorphisés sur une épaisseur de 30 nm par implantation de Ge à une dose de 1×10¹⁵ ions/cm² avec une énergie d'implantation sensiblement égale à 5 keV, et dopés par implantation de Bore à une dose de 1×10¹⁵ ions/cm² avec une énergie d'implantation sensiblement égale à 2 keV.

Dans cette configuration et toujours avec un laser XeCl, la fusion de la couche amorphisée 10 peut être constatée pour une densité d'énergie supérieure ou égale 1,05 J/cm². Pour comparaison, la fusion d'un échantillon équivalent mais non amorphisé intervient à partir de 1,40 J/cm². La recristallisation en phase solide de la couche amorphisée 10 peut donc être initiée à une densité d'énergie inférieure 1,05 J/cm².

Des essais de recristallisation ont été effectués à densité d'énergie constante en appliquant jusqu'à 1000 tirs laser sur une même zone 100 à 1,00 ou 0,95 J/cm². La recristallisation n'est que partielle dans ces conditions. Ceci illustre que, dans ce cas, un procédé à densité d'énergie constante selon l'art antérieur ne permet pas de parvenir au résultat désiré.

Dans la même configuration et toujours avec le laser susmentionné, des exemples de mise en œuvre du procédé selon l'invention ont permis de revenir à une couche monocristalline de SiGe avec les conditions suivantes :
a. Une densité d'énergie initiale, EDᵢ, égale à 0.85 J/cm²
b. Une densité d'énergie finale, ED_{f}, égale 1,25 J/cm²
c. Un incrément en densité d'énergie, δED, égal à 25 ou 50 ou 100 mJ/cm²,
d. Un nombre N de tirs sur une même zone 100, pour une même densité d'énergie, égal à 30 ou 100.

Dans le cas où 30 tirs sont pratiqués pour chaque niveau de densité d'énergie, la recristallisation complète est ici obtenue à l'aide de 510 tirs, à comparer avec les 1000 tirs à énergie constante qui ne permettent pas une cristallisation correcte.

L'invention n'est pas limitée aux modes de réalisations précédemment décrits.

Par exemple, les résultats donnés ci-dessus ont été obtenus à nombre de tirs constant par niveau de densité d'énergie ; il est toutefois également possible de jouer sur une variation de ce nombre de tirs par niveau de densité d'énergie, de sorte à optimiser encore l'adaptation du recuit à l'évolution du front de cristallisation.

Par exemple, les résultats donnés ci-dessus ont été obtenus à incrément en densité d'énergie, δED, constant entre chaque série ; il est toutefois également possible de jouer sur une variation de cet incrément d'une série à une autre, de sorte à optimiser encore l'adaptation du recuit à l'évolution du front de cristallisation.

Par exemple, les résultats donnés ci-dessus ont été obtenus à durée d'impulsions constante ; il est toutefois également possible de jouer sur une variation, par exemple d'une série à une autre, de cette durée d'impulsions, dont dépend la densité d'énergie des impulsions, de sorte à optimiser encore l'adaptation du recuit à l'évolution du front de cristallisation.

Par exemple, si les exemples donnés ci-dessus concernent le cas d'impulsions laser 2 dont la longueur d'onde se situe dans le domaine spectral des ultraviolets (par exemple à 293 nm, 308 nm ou 355 nm), il n'est pas exclu que la longueur d'onde des impulsions puisse être choisie comme se situant dans le bleu, dans le vert (par exemple à 532 nm), voire même dans le rouge (par exemple à 633 ou 850nm).

Par exemple, si l'utilisation de laser à l'état solide semble à privilégier, celles de laser à gaz ne peut pas être exclue. Ces derniers peuvent présenter l'avantage de permettre de changer la durée des impulsions 2, ce qui peut constituer un paramètre d'optimisation supplémentaire. Toutefois, il reste plus simple de faire varier le nombre de tirs par niveau de densité d'énergie et/ou la densité d'énergie des tirs en changeant de laser.

## Revendications

1. Procédé de cristallisation d'au moins une partie d'une couche amorphe (10) à base d'un premier matériau, la couche amorphe (10) :
• étant comprise dans un empilement (1) comprenant en outre une couche cristalline (11),
• s'étendant directement au contact de la couche cristalline (11) de l'empilement (1) en formant une interface (102) avec la couche cristalline (11), et
• présentant une première face (101) opposée à l'interface (102), et
• présentant, un seuil de fusion noté E_{M}, correspondant à la densité d'énergie à apporter à la couche amorphe (10) pour atteindre une fusion du premier matériau, pour une épaisseur Ep de la couche amorphe (10) définie entre la première face (101) et l'interface (102),
le procédé comprenant un recuit de cristallisation de la couche amorphe (10) en la soumettant, par zones (100), à des impulsions laser (2), et
le procédé étant **caractérisé en ce que**, en chaque zone (100), les impulsions laser (2) sont émises par séries d'impulsions, chaque impulsion laser (2) présentant une densité d'énergie EDᵢ différente d'une série à une autre de sorte à maintenir la densité d'énergie des impulsions (2) de chaque série en dessous du seuil de fusion E_{M}, ce dernier évoluant à mesure que la couche amorphe (10) cristallise.

2. Procédé selon la revendication précédente, dans lequel la densité d'énergie EDᵢ des impulsions de chaque série est choisie de sorte que EDᵢ < E_{M}-8%×E_{M} et de préférence de sorte que EDᵢ < E_{M}-5%×E_{M}, et encore plus préférentiellement de sorte que EDᵢ < E_{M}-2%×E_{M}.

3. Procédé selon l'une quelconque des revendications précédentes, dans lequel la densité d'énergie EDᵢ des impulsions de chaque série est choisie de sorte que EDᵢ ≥ E_{M}-20%×E_{M} et de préférence de sorte que EDᵢ ≥ E_{M}-15%×E_{M}, et encore plus préférentiellement de sorte que EDᵢ ≥ E_{M}-10%×E_{M}.

4. Procédé selon l'une quelconque des revendications précédentes, comprenant, avant le recuit de cristallisation de la couche amorphe (10), une première implantation configurée pour doper la couche amorphe (10), par implantation, dans la couche amorphe (10), de dopants, tels que As, Ga, B, P et Sb.

5. Procédé selon l'une quelconque des revendications précédentes, comprenant, avant le recuit de cristallisation de la couche amorphe (10), une deuxième implantation configurée pour former la couche amorphe (10), par implantation, dans la couche amorphe (10), d'ions, dits lourds, tels que Si, Ge, Xe et Ar.

6. Procédé selon les deux revendications précédentes, dans lequel la deuxième implantation dite 'amorphisante' est réalisée avant la première implantation dite 'dopante'.

7. Procédé selon l'une quelconque des revendications précédentes, dans lequel l'épaisseur initiale de la couche amorphe est strictement supérieure à 20 nm, et par exemple supérieure ou égale à 25 nm.

8. Procédé selon l'une quelconque des revendications précédentes, dans lequel l'un au moins parmi le premier matériau et le matériau à base duquel est constituée la couche cristalline (11) est choisi parmi : Si, SiGe, Ge, SiC, GeSn et le diamant.

9. Procédé selon l'une quelconque des revendications précédentes, dans lequel chaque série d'impulsions laser (2) comprend entre 1 et 1000 impulsions, de préférence entre 5 et 50 impulsions.

10. Procédé selon l'une quelconque des revendications précédentes, dans lequel la différence δED de densité d'énergie EDᵢ d'une série à une autre est comprise entre 5 et 100 mJ/cm², en particulier dans le cas d'impulsions laser (2) dont la longueur d'onde se situe dans le domaine spectral des ultraviolets.

11. Procédé selon l'une quelconque des revendications précédentes, dans lequel un intervalle de temps entre deux impulsions laser (2) en une même zone (100) est paramétré de sorte que l'empilement (1) ait le temps de revenir à une température sensiblement égale à sa température avant réception d'une première des deux impulsions laser (2).

12. Procédé selon l'une quelconque des revendications précédentes, dans lequel un intervalle de temps entre deux impulsions laser (2) en une même zone (100) est au minimum de 1 ms, en particulier dans le cas d'impulsions laser dont la longueur d'onde se situe dans le domaine spectral des ultraviolets.

13. Procédé selon l'une quelconque des revendications précédentes, dans lequel les impulsions laser présentent une longueur d'onde située dans le domaine spectral des ultraviolets, et typiquement choisie parmi les valeurs suivantes : 293 nm, 308 nm et 355 nm.

14. Procédé selon l'une quelconque des revendications précédentes, dans lequel une durée de chaque impulsion laser (2) est inférieure ou égale à 3000 ns, préférentiellement inférieure ou égale à 1000 ns, et typiquement comprise entre 10 et 300 ns.

15. Procédé selon l'une quelconque des revendications précédentes, dans lequel l'empilement (1) est compris dans une structure (0) micro/nanoélectronique, par exemple de type SOI, de type CMOS, ou de type jonction p-n.

## Patentansprüche

1. Verfahren zur Kristallisation mindestens eines Teils einer amorphen Schicht (10) auf Grundlage eines ersten Materials, wobei die amorphe Schicht (10):
• in einer Stapelung (1) enthalten ist, die außerdem eine kristalline Schicht (11) umfasst,
• sich direkt in Berührung mit der kristallinen Schicht (11) der Stapelung (1) erstreckt, indem eine Grenzfläche (102) mit der kristallinen Schicht (11) gebildet wird, und
• eine erste Fläche (101) aufweist, die der Grenzfläche (102) entgegengesetzt ist, und
• eine mit E_{M} bezeichnete Fusionsschwelle aufweist, die der Dichte der Energie entspricht, die der amorphen Schicht (10) zugeführt werden muss, um eine Fusion des ersten Materials für eine Dicke Ep der amorphen Schicht (10), die zwischen der ersten Fläche (101) und der Grenzfläche (102) definiert ist, zu erreichen,
wobei das Verfahren ein Kristallisationsglühen der amorphen Schicht (10) umfasst, indem sie nach Zonen (100) Laserimpulsen (2) ausgesetzt wird, und
das Verfahren **dadurch gekennzeichnet ist, dass** in jeder Zone (100) die Laserimpulse (2) in Impulsserien emittiert werden, wobei jeder Laserimpuls (2) eine Energiedichte EDᵢ aufweist, die von einer Serie zu einer anderen derart unterschiedlich ist, dass die Energiedichte der Impulse (2) jeder Serie unter der Fusionsschwelle E_{M} gehalten wird, wobei sich diese Letztere im Laufe des Kristallisierens der amorphen Schicht (10) weiterentwickelt.

2. Verfahren nach dem vorstehenden Anspruch, wobei die Energiedichte EDᵢ der Impulse jeder Serie derart ausgewählt wird, dass EDᵢ < E_{M}-8 %*E_{M} und bevorzugt derart, dass EDᵢ < E_{M}-5 %*E_{M}, und noch bevorzugter derart, dass EDᵢ < E_{M} - 2 %xE_{M}.

3. Verfahren nach einem der vorstehenden Ansprüche, wobei die Energiedichte EDᵢ der Impulse jeder Serie derart ausgewählt wird, dass EDᵢ ≥ E_{M} - 20 %*E_{M} und bevorzugt derart, dass EDᵢ ≥ E_{M} -15 %*E_{M}, und noch bevorzugter derart, dass EDᵢ ≥ E_{M} -10 %*E_{M}.

4. Verfahren nach einem der vorstehenden Ansprüche, das vor dem Kristallisationsglühen der amorphen Schicht (10) eine erste Implantation umfasst, die dazu konfiguriert ist, die amorphe Schicht (10) durch Implantation in der amorphen Schicht (10) von Dotierstoffen wie As, Ga, B, P und Sb zu dotieren.

5. Verfahren nach einem der vorstehenden Ansprüche, das vor dem Kristallisationsglühen der amorphen Schicht (10) eine zweite Implantation umfasst, die dazu konfiguriert ist, die amorphe Schicht (10) durch Implantation in der amorphen Schicht (10) sogenannter schwerer Ionen wie Si, Ge, Xe und Ar zu bilden.

6. Verfahren nach den zwei vorstehenden Ansprüchen, wobei die zweite als "amorphisierend" bezeichnete Implantation vor der als "dotierend" bezeichneten Implantation durchgeführt wird.

7. Verfahren nach einem der vorstehenden Ansprüche, wobei die anfängliche Dicke der amorphen Schicht strikt höher ist als 20 nm und beispielsweise höher oder gleich 25 nm ist.

8. Verfahren nach einem der vorstehenden Ansprüche, wobei mindestens eines des ersten Materials und des Materials, auf dessen Grundlage die kristalline Schicht (11) gebildet ist, ausgewählt ist aus: Si, SiGe, Ge, SiC, GeSn und Diamant.

9. Verfahren nach einem der vorstehenden Ansprüche, wobei jede Serie von Laserimpulsen (2) zwischen 1 und 1000 Impulse, bevorzugt zwischen 5 und 50 Impulse umfasst.

10. Verfahren nach einem der vorstehenden Ansprüche, wobei der Unterschied δED der Energiedichte EDᵢ von einer Serie zu einer anderen zwischen 5 und 100 mJ/cm2 liegt, insbesondere in dem Fall von Laserimpulsen (2), deren Wellenlänge in dem Ultraviolett-Spektralbereich liegt.

11. Verfahren nach einem der vorstehenden Ansprüche, wobei ein Zeitintervall zwischen zwei Laserimpulsen (2) in derselben Zone (100) derart parametriert ist, dass die Stapelung (1) über Zeit verfügt, zu einer Temperatur zurückzukehren, die im Wesentlichen gleich ihrer Temperatur vor Empfang eines ersten der beiden Laserimpulse (2) ist.

12. Verfahren nach einem der vorstehenden Ansprüche, wobei ein Zeitintervall zwischen zwei Laserimpulsen (2) in derselben Zone (100) mindestens 1 ms beträgt, insbesondere in dem Fall von Laserimpulsen, deren Wellenlänge in dem Ultraviolett-Spektralbereich liegt.

13. Verfahren nach einem der vorstehenden Ansprüche, wobei die Laserimpulse eine Wellenlänge aufweisen, die in dem Ultraviolett-Spektralbereich liegt und in der Regel aus den folgenden Werten ausgewählt wird: 293 nm, 308 nm und 355 nm.

14. Verfahren nach einem der vorstehenden Ansprüche, wobei eine Dauer jedes Laserimpulses (2) kleiner oder gleich 3000 ns, bevorzugt kleiner oder gleich 1000 ns ist und in der Regel zwischen 10 und 300 ns liegt.

15. Verfahren nach einem der vorstehenden Ansprüche, wobei die Stapelung (1) in einer mikro-/nanoelektronischen Struktur (0) enthalten ist, beispielsweise vom Typ SOI, vom Typ CMOS oder vom Typ p-n-Übergang ist.

## Claims

1. Method for crystallising at least one part of an amorphous layer (10) with the basis of a first material, the amorphous layer (10):
- being comprised in a stack (1) further comprising a crystalline layer (11),
- extending directly in contact with the crystalline layer (11) of the stack (1) by forming an interface (102) with the crystalline layer (11), and
- having a first face (101) opposite the interface (102), and
- having, a melting threshold referenced E_{M}, corresponding to the energy density to be provided to the amorphous layer (10) to achieve a melting of the first material, for a thickness Ep of the amorphous layer (10) defined between the first face (101) and the interface (102),
the method comprising a crystallisation annealing of the amorphous layer (10) by subjecting it, by zones (100), to laser pulses, and
the method being **characterised in that**, in each zone (100), the laser pulses (2) are emitted by series of pulses, each laser pulse (2) having an energy density EDᵢ different from one series to another, so as to maintain the energy density of the pulses (2) of each series below the melting threshold E_{M}, the latter developing as the amorphous layer crystallises.

2. Method according to the preceding claim, wherein the energy densities EDᵢ of the pulses of each series is chosen, such that EDᵢ < Eₘ-8%xEₘ, and preferably such that EDᵢ < E_{M}-5%xE_{M}, and even more preferably, such that EDᵢ < E_{M}-2%xE_{M}.

3. Method according to any one of the preceding claims, wherein the energy density EDᵢ of the pulses of each series is chosen, such that EDᵢ ≥ E_{M}-20%xE_{M}, and preferably such that EDᵢ≥ E_{M}-15%xE_{M}, and even more preferably, such that EDᵢ ≥ E_{M}-10%xE_{M}.

4. Method according to any one of the preceding claims, comprising, before the crystallisation annealing of the amorphous layer (10), a first implantation configured to dope the amorphous layer (10), by implantation, in the amorphous layer (10), with dopants, such as As, Ga, B, P and Sb.

5. Method according to any one of the preceding claims, comprising, before the crystallisation annealing of the amorphous layer (10), a second implantation configured to form the amorphous layer (10), by implantation, in the amorphous layer (10), of so-called heavy ions, such as Si, Ge, Xe and Ar.

6. Method according to the two preceding claims, wherein the second so-called "amorphising" implantation is done before the first so-called "doping" implantation.

7. Method according to any one of the preceding claims, wherein the initial thickness of the amorphous layer is strictly greater than 20nm, and for example greater than or equal to 25nm.

8. Method according to any one of the preceding claims, wherein the at least one from among the first material and the material with the basis of which is crystalline layer (11) is constituted can be chosen from among: Si, SiGe, Ge, SiC, GeSn and diamond.

9. Method according to any one of the preceding claims, wherein each series of laser pulses (2) comprises between 1 and 1000 pulses, preferably between 5 and 50 pulses.

10. Method according to any one of the preceding claims, wherein the difference δED of energy density EDᵢ from one series to another is between 5 and 100mJ/cm², in particular in the case of laser pulses (2), the wavelength of which is located in the ultraviolet spectral domain.

11. Method according to any one of the preceding claims, wherein a time interval between two laser pulses (2) in one same zone (100) is configured, such that the stack (1) has the time to return to a temperature substantially equal to its temperature before receiving a first of the two laser pulses (2).

12. Method according to any one of the preceding claims, wherein a time interval between two laser pulses (2) in one same zone is (100), as a minimum, 1ms, in particular in the case of laser pulses, the wavelength of which is located in the ultraviolet spectral domain.

13. Method according to any one of the preceding claims, wherein the laser pulses have a wavelength located in the ultraviolet spectral domain, and typically chosen from among the following values: 293nm, 308nm and 355nm.

14. Method according to any one of the preceding claims, wherein a duration of each laser pulse (2) is less than or equal to 3000ns, preferably less than or equal to 1000ns, and typically between 10 and 300ns.

15. Method according to any one of the preceding claims, wherein the stack (1) is comprised in a micro/nanoelectronic structure (0), for example of the SOI-, of the CMOS-, or of the p-n junction-type.
